# EUROPEAN PATENT SPECIFICATION

(11) **EP 3 795 961 B1**
(45) Date of publication and mention of the grant of the patent: **06.09.2023**
(21) Application number: 19382806.8
(22) Date of filing: 17.09.2019
(51) Int. Cl.: G01J 1/02, G01J 1/42, B82Y 20/00, G01J 1/44

(54) **A SUPERCONDUCTING NANOWIRE SINGLE-PHOTON DETECTOR, AND A METHOD FOR OBTAINING SUCH DETECTOR**
SUPRALEITENDER NANODRAHTEINZELPHOTONENDETEKTOR UND VERFAHREN ZUR HERSTELLUNG SOLCH EINES DETEKTORS
DÉTECTEUR MONOPHOTONIQUE À NANOFIL SUPRACONDUCTEUR ET PROCÉDÉ D'OBTENTION D'UN TEL DÉTECTEUR

(43) Date of publication of application: 24.03.2021
(73) Proprietor: Fundació Institut de Ciències Fotòniques, 08860 Castelldefels (ES)
(72) Inventor: EFETOV, Dimitri K., 08860 CASTELLDEFELS (ES); LU, Xiaobo, 08860 CASTELLDEFELS (ES); ALI, Aamir M., 08860 CASTELLDEFELS (ES); SEIFERT, Paul, 08860 CASTELLDEFELS (ES); DURÁN, José, 08860 CASTELLDEFELS (ES)
(74) Representative: Ponti & Partners, S.L.P

(56) References cited:
- WO-A1-2017/040598
- US-A1- 2016 340 533
- RICCARDO ARPAIA ET AL: "Transport properties of ultrathin YBa_2Cu_3O_7-delta nanowires: a route to single photon detection", ARXIV.ORG, CORNELL UNIVERSITY LIBRARY, 201 OLIN LIBRARY CORNELL UNIVERSITY ITHACA, NY 14853, 16 August 2017 (2017-08-16), XP080953046, DOI: 10.1103/PHYSREVB.96.064525
- ALEXANDER S. MAYOROV ET AL: "Micrometer-Scale Ballistic Transport in Encapsulated Graphene at Room Temperature", NANO LETTERS, vol. 11, no. 6, 8 June 2011 (2011-06-08), pages 2396-2399, XP055674306, US ISSN: 1530-6984, DOI: 10.1021/nl200758b

## Description

### FIELD OF THE INVENTION

The present invention relates, in a first aspect, to a superconducting nanowire single-photon detector which can operate above the temperature corresponding to the boiling point of liquid nitrogen.

A second aspect of the present invention relates to a method for obtaining the superconducting nanowire single-photon detector of the first aspect of the present invention.

### BACKGROUND OF THE INVENTION

In recent years Superconducting Nanowire Single-Photon Detectors (SNSPD), also known just as Superconducting Single-Photon Detectors (SSPDs), have developed into some of the most advanced superconducting photodetectors (SPDs), and were key enabling technologies in the development of revolutionary quantum communication protocols, such as quantum key distribution and the Bells inequality test. Based on local heating and hot spot creation in ultra-thin superconducting (SC) nanowires, however, these detectors can be only operated inside large cryogenic refrigerators at ultra-low operation temperatures < 3K. This makes the packaging of SNSPDs extremely impractical and expensive, and their application is limited to academic research.

Superconducting nanowire single-photon detectors including the features of the preamble of claim 1 are known in the art, i.e. comprising a superconducting nanowire configured and arranged for the incidence of a photon on a region thereof and the formation, on said region, of a localized non-superconducting region or hotspot.

However, those already known detectors, such as that disclosed in US6812464B1, have several drawbacks, mainly associated to the type of superconducting material used for forming the superconducting nanowire or nanostrip, which is generally of a low quality, and to the method needed for using the same to form the superconducting nanowire or nanostrip (generally, a sputtering process), which make them operable only under the above mentioned ultra-low operation temperatures. The article "Transport properties of ultrathin YBa_2Cu_3O_7-delta nanowires: a route to single photon detection", by Arpaia et al, discloses the use of ultrathin YBCO nanowires down to below 10nm.

The use of high-Tc cuprate superconductor materials is known for providing different devices (such as Low Pass Filters) for several applications, but always in a relatively thick form (around 100 nm), thick enough so that their surface degradation due to oxidation when exposed to air has a null or negligible effect on the operation of those devices, as their operation is based on the core properties of the relatively thick high-Tc cuprate superconductor material elements included therein.

It is, therefore, necessary to provide an alternative to the state of the art which covers the gaps found therein, by providing a SNSPD which does not have the above mentioned drawbacks associated to the SNSPDs known in the art.

### SUMMARY OF THE INVENTION

To that end, the present invention relates, in a first aspect, to a superconducting nanowire single-photon detector, as defined in claim 1, comprising a superconducting nanowire, or superconducting nanostrip, configured and arranged for the incidence of a photon on a region thereof and the formation, on said region, of a localized non-superconducting region or hotspot.

In contrast to the superconducting nanowire single-photon detectors known in the prior art, in the one of the first aspect of the present invention, in a characterizing manner, the superconducting nanowire or nanostrip is made of a high-Tc cuprate superconductor material having a superconducting critical temperature above 77 K.

By means of the first aspect of the present invention the advanced properties of SNSPDs are transferred to a wider field of practical applications beyond the use in laboratories, as, in contrast to conventional superconductor materials, the high-Tc cuprate superconductor material allows the operation of SNSPDs even when merely cooled with liquid nitrogen, which makes the detector operation much more affordable and easily managed than those of the prior art.

For an embodiment, the above mentioned region is constituted by a portion of the superconducting nanowire, while for another embodiment that region is constituted by the whole superconducting nanowire.

According to the invention, the thickness of the superconducting nanowire is below 1.7 nm.

According to a preferred embodiment, the high-Tc cuprate superconductor material is a 2D single-crystal material, while for another embodiment is a quasi-2D single-crystal material.

According to the invention, the high-Tc cuprate superconductor material is at least one of Bi₂Sr₂Ca₂Cu₃O₁₀, Bi₂Sr₂CaCu₂O₈, YBa₂Cu₃O₇, Tl₂Ba₂CuO₆, Tl₂Ba₂CaCu₂O₈, Tl₂Ba₂Ca₂Cu₃O₁₀, TlBa₂Ca₃Cu₄O₁₁, HgBa₂CuO₄, HgBa₂CaCu₂O₆, HgBa₂Ca₂Cu₃O₈, or a combination thereof.

For an embodiment, the superconducting nanowire is hermetically air- and water-sealed by means of a sealing material, so that surface degradation by oxidation is avoided.

According to an implementation of that embodiment, the superconducting nanowire is encapsulated by the above mentioned sealing material, wherein that sealing material is an air-impenetrable van der Waals material which is transparent to at least a wavelength of an electromagnetic wave associated to the above mentioned photon, i.e. to the photon to be detected.

Preferably, the superconducting nanowire single-photon detector of the first aspect of the present invention is configured to detect photons of any wavelength within a broad light wavelength spectrum (from the ultra violet to mid infrared), although configuring the detector for detecting photons within narrower light wavelength spectrums is also feasible for other embodiments.

According to a further embodiment, the superconducting nanowire single-photon detector of the first aspect of the present invention further comprises two or more electrodes arranged and making electrical contact with respective locations of the superconducting nanowire longitudinally distanced from each other, wherein the two or more electrodes are operatively connected with a control unit to current bias the superconducting nanowire and/or to read-out an electrical signal caused or modified by the above mentioned hotspot formation.

For an embodiment, the superconducting nanowire single-photon detector further comprising a cooler configured and arranged to maintain the temperature of the above mentioned region of the superconducting nanowire above 77 K and below 120K.

For a further embodiment, the superconducting nanowire single-photon detector further comprises a vacuum cell housing the superconducting nanowire, and having direct optical access to direct a single-photon towards at least the above mentioned region of the superconducting nanowire.

According to a further embodiment, the superconducting nanowire or nanostrip is placed (for example, by a nanopatterning technique) on a photonic crystal cavity, in order to increase its light absorption.

The present invention also relates, in a second aspect, to a method for obtaining a superconducting nanowire single-photon detector, as defined in claim 8.

In contrast to the methods known in the prior art, in the one of the second aspect of the present invention, in a characterizing manner, said superconducting nanowire or nanostrip is made of a high-Tc cuprate superconductor material having a superconducting critical temperature above 77 K.

Preferably, the method of the second aspect of the present invention comprises carrying out the above mentioned step of providing the superconducting nanowire under an inert ambient, so that oxidation thereof is avoided.

For an embodiment, the method of the second aspect of the present invention further comprises hermetically air- and water- sealing the superconducting nanowire by applying, while in the inert ambient, a sealing material thereon.

According to an implementation of that embodiment, the method of the second aspect of the present invention comprises carrying out the above mentioned step of applying a sealing material by encapsulating the superconducting nanowire, under the inert ambient, with an air-impenetrable van der Waals material which is transparent to at least a wavelength of an electromagnetic wave associated to the above mentioned photon, i.e. to the photon to be detected.

According to an embodiment, the method of the second aspect of the present invention comprises:
- providing a dielectric substrate with pre-patterned electrodes;
- exfoliating, under the inert ambient, a superconducting flake(s) from a high-Tc cuprate superconductor material bulk crystal and transferring, while in the inert ambient, the exfoliated superconducting flake(s) onto the dielectric substrate such that it is attached thereon properly aligned to make electrical contact with the pre-patterned electrodes at respective locations of the superconducting exfoliated flake(s);
- providing the air-impenetrable van der Waals material, under the inert ambient, by exfoliating the same from an air-impenetrable van der Waals material bulk crystal, and transferring the exfoliated air-impenetrable van der Waals flake(s) at least on top of the already transferred exfoliated superconducting flake(s); and
- etching the exfoliated air-impenetrable van der Waals flake(s) and the superconducting exfoliated flake(s) according to a predetermined pattern to obtain the superconducting nanowire encapsulated in the air-impenetrable van der Waals material, in the form of an etched stack.

For a variant of said embodiment, the method further comprises providing a further air-impenetrable van der Waals material at least on top of the etched stack, to fully encapsulate the superconducting nanowire. That further air-impenetrable van der Waals material is provided in the same manner as the previously provided air-impenetrable van der Waals material, i.e. by carrying out, under the inert ambient, the exfoliation of the same from an air-impenetrable van der Waals material bulk crystal, and the transfer of the exfoliated air-impenetrable van der Waals flake(s) at least on top of the etched stack, covering etched and non-etched areas.

The method of the second aspect of the present invention comprises obtaining the SNSPD of the first aspect of the present invention for any of its embodiments.

The types of 2D superconductors used in the present invention (i.e. high-Tc cuprate superconductors) can exhibit superconductivity in layers that are up to 10x thinner than for sputtered materials. This leads to a reduced heat capacity and therefore the detectivity of longer wavelength light. In addition the hot-spots can be larger, and the nanowire can be therefore wider, making fabrication much more reliable.

2D high-Tc cuprate superconductor materials are ultra-clean, single crystals, with a low intrinsic carrier density. Therefore they do not suffer inhomogeneities at grain boundaries, while heavily limit fabrication reliability in traditional SNSPDs. Therefore more precise and uniform patterning should be possible, leading to a lower dark count and potentially improved jitter time.

Also, the high-Tc cuprate superconductor materials used in the present invention as any 2D material, can be transferred and fabricated on any substrate (silicon, silicon oxide, sapphire, quartz, diamond, etc.), leading to ease the integration with photonics platforms, such as any type of resonant photonic structures for visible, near-IR and mid-IR light, like photonic crystal cavities, dBR cavities and many more. The high-Tc cuprate superconductor can also be critically coupled to antennas for THz light and lambda-half cavities for GHz wavelengths, allowing for enhanced light absorption and hence quantum efficiency (QE) of the device.

Moreover, the 2D high-Tc cuprate superconductor material used in the present invention offer elevated superconductor temperatures up to 120K. This leads to an operation temperature that can be achieved with LN2 (Liquid Nitrogen) or cryocoolers. This leads to a strong simplification of packaging and vastly improved applicability as a direct integration into microscopes and direct light coupling is possible. Overall it makes packaging much cheaper.

Therefore, by means of the present invention, an SNSPD is provided which, depending on the embodiment, has some or all of the following key advantages with respect to a conventional SNSPD (such as that of US6812464B1):
- Higher superconducting transition temperature (above 77 K, and up to 120 K), which revolutionizes packaging, making it orders of magnitude smaller and cheaper.
- Ultra clean single crystal superconductor, which provides lower dark counts.
- Its 2D material properties allows ease of integration onto silicon photonics platforms, which allows to engineer much higher quantum efficiency (QE), close to unity.
- The superconducting material can be much thinner than in US6812464B1, which makes the thermal properties much more favourable, allowing much wider nanowires, which involves strong improvement in fabrication yield.
- The operation wavelength can be increased up to at least mid IR - 20µm.
- The quantum efficiency (QE) is enhanced to about 90%.
- Inert atmosphere van der Waals (vdW) fabrication and encapsulation techniques, make the device stable under ambient conditions and allow its preparation into thin films and nanostructures.

The present invention has several possible applications, such as:
- Those related to quantum communication protocols, such as quantum key distribution and the Bells inequality test.
- Radioastronomy, where the interest is in detecting long wavelength single-photons (mid-IR to THz wavelengths). Here there is no competing technology, so the detector of the present invention could be an enabling technology.
- SNSPD based image arrays, cameras for low light microscopy. Indeed, SNSPD package of the present invention can have a micro-miniature size (due to the high operating temperature), which allows seamless integration into any commercially available microscope, and the orders of magnitude reduced cost of the package will revolutionize the applicability of SNSPDs to a much broader range of technologies.

### BRIEF DESCRIPTION OF THE FIGURES

In the following some preferred embodiments of the invention will be described with reference to the enclosed figures. They are provided only for illustration purposes without however limiting the scope of the invention.
Fig. 1: Atomic force microscopy image of a 3-unit cell thick BSCCO thin film, which corresponds to a film thickness of 9nm. BSCCO films that were mechanically exfoliated in an inert atmosphere according to the method of the second aspect of the present invention, for an embodiment. It shows a clean and sharp interface and a homogenous thickness over length scales 10-1000 µm.
Fig. 2: Raman spectroscopy on thick (54nm) and 4-unit cell thick (12nm) BSCCO used for an embodiment of the detector and method of the present invention. Ultra-thin films retain the crystallographic stability and quality and show the same Raman active modes as bulk crystals. The different Raman modes can be found in (PRB, 45, 13, 7392 (1992)).
Fig. 3: Microscope image of large area BSCCO single crystals with 5 layer thickness and shadow mask evaporated Ag electrodes for electrical contact, used for an embodiment of the detector and method of the present invention.
Fig. 4: Diagram displaying the longitudinal resistance Rₓₓ as a function of temperature T of a 5-unit cell thick multi-terminal device. From the graph a superconducting transition temperature of T_{c} > 77K is obtained. The inset image shows the microscope image of the device.
Fig. 5: Cross-section of a schematic representation of the SNSPD of the first aspect of the present invention, for an embodiment, where a vdW superconductor thin film, i.e. the high-Tc superconductor nanowire, is encapsulated with vdW sealing materials. The encapsulation into vdW hinders air to penetrate to the superconductor thin film, making it stable under ambient conditions. The superconductor thin film is in contact with evaporated metals, like Ag or Au, which implement respective contact electrodes.
Fig. 6. Cross sectional images of different stages of a photolithography process carried out by a laser writer to pattern the bottom electrodes of the SNSPD according to an embodiment of the method of the second aspect of the present invention.
Fig. 7: a. Top schematic of the SNSPD of the first aspect of the present invention, for an embodiment, b. Perspective view of a portion of the high- Tc nanowire 12 depicted in Fig. 7a.
Fig. 8. Cross sectional images of the stages of a deterministic dry transfer method by PDMS to transfer BSCCO flake on a pre-patterned bottom electrode substrate according to an embodiment of the method of the second aspect of the present invention.
Fig. 9. Cross sectional images of the stages of a deterministic dry transfer method by PDMS to transfer hBN flake on the pre-patterned bottom electrode substrate according to an embodiment of the method of the second aspect of the present invention.
Fig. 10. Top view illustration of two etching masks (a and b) to pattern BSCCO/hBN stacks into (c) short rod-like nanoribbons and (d) long meander-like nanoribbons according to two different embodiments of the method of the second aspect of the present invention.
Fig. 11. Cross sectional images of the stages of: (a) EBL, (b) CHF₃/O₂ plasma etching, (c) Ar ion milling, (d) lift-off process, and (e) hBN encapsulation processes, according to an embodiment of the method of the second aspect of the present invention.
Fig. 12. (a) Optical image of BSCCO flake on PDMS. (b) Transferred BSCCO flake on the Au-electrode pre-patterned Si/SiO₂ substrate. Scale bar is 20 µm. (c) Optical image of an hBN flake on PDMS. (d) Transferred hBN flake on the BSCCO/Au-electrode pre-patterned Si/SiO₂ substrate. Scale bar is 20 µm (e) AFM topography image of the dashed area in (d), and (f) height profile extracted from the dashed line in (e). The Figure illustrates different steps of the method of the second aspect of the present invention, for an embodiment.
Fig. 13. SEM images of a 6-unit cell BSCCO flake patterned by EBL and Ar ion milling processes into (a) six-loop meander and (b) five-loop meander with different widths and spaces, according to two embodiments of the device and method of the present invention.

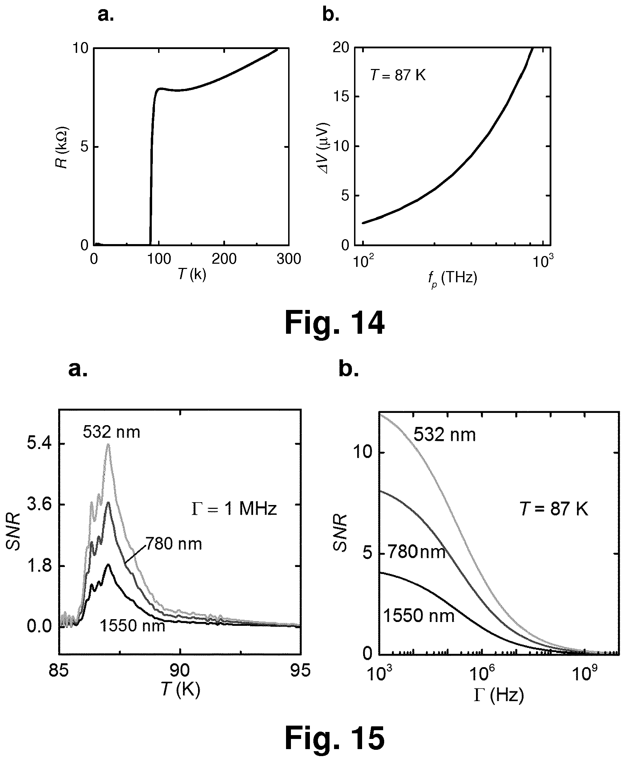

Fig. 14 shows two diagrams displaying performance results obtained from a BSCCO nanowire detector experimentally built to implement the SNSPD of the first aspect of the present invention, for an embodiment, a. Exemplary resistance of a 100 µm long and 100 nm thin nanowire. The critical temperature of this particular device is 88 K. b. Voltage response ΔV as a function of the photon frequency *f*ₚ for an applied bias current of 1 µA. The present inventors found a sizable voltage response in the visible up to IR spectrum. The preferred operation wavelengths range from telecommunication wavelength (1550 nm) to the visible and ultraviolet spectrum (300 nm).
Fig. 15 shows two further diagrams also displaying performance results obtained from the same BSCCO nanowire detector as in Figure 14. a. Expected signal to noise ratio (SNR) of the detector as a function of the device temperature for photons at telecom (1550 nm), NIR (780 nm) and visible (532 nm) wavelengths. The calculations are based on the intrinsic noise from the sample at a detector bandwidth Γ of 1 MHz from a sample comprising a critical temperature of 88 K. Depending on the critical temperature of the used superconductor the single-photon detector can be operated at temperatures between 0 K up to temperatures as high as 120 K. b. Signal to noise ratio of the detector at a temperature just below the critical temperature as a function of the detector bandwidth for an applied bias current of 1 µA. In general, a SNR greater than one is necessary in order to distinguish the detector signal from the noise background.

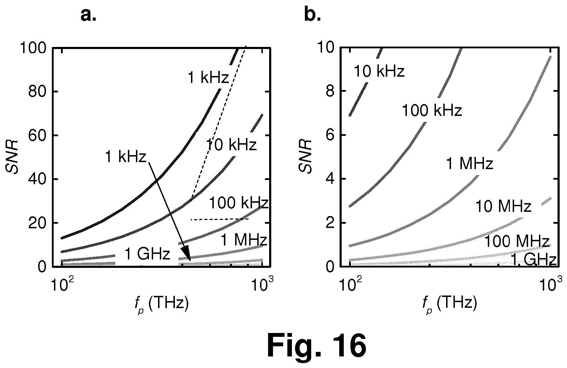

Fig. 16 also shows two further diagrams displaying performance results of the same BSCCO as in Figures 14 and 15. a. Signal to noise ratio (SNR) as a function of the photon frequency for different detector bandwidths for an applied bias current of 1 µA. b. Same data as in (a) but on a SNR scale of 0-10 For increasing bandwidth, the detection threshold is shifted towards higher photon frequencies. For experiments up to the 1 MHz regime the detector can operate with a reasonable signal to noise ratio for detecting wavelengths at or above telecommunication wavelength (1550 nm). For wavelengths in the visible and ultraviolet, the detection bandwidth can be extended to about 10 MHz.

### DESCRIPTION OF THE PREFERRED EMBODIMENTS

In the present section some working embodiments of the detector and method of the present invention will be described in detail.

Particularly, a SNSPD with a very thin film thickness has been built by the present inventors in order to allow a reasonable detector performance, using the high-Tc cuprate superconductor Bismuth Strontium Calcium Copper Oxide (BSCCO). BSCCO belongs to the entirely novel class of strictly two-dimensional (2D) van der Waals (vdW) materials, which only recently have emerged. In contrast to other high-Tc superconductors BSCCO can be mechanically prepared with a film thickness of 1.5 nm corresponding to only half a crystallographic unit cell. In addition, being 'cousins' of the wonder material graphene, these ultra-clean single-crystals have far superior material quality than the strongly disordered superconductor thin films of NbN or WSi which are used for state-of-the-art SNSPDs. Having a > 10 times reduced thickness, 2D superconductors have an ultra-low heat capacity, which results in superior hot spot creation, and hence an improved DCR (Dark Count Rate). In addition, the detectors single-photon sensitivity can be extended to previously inconceivable wavelengths for single-photon detectors of deep mid-IR to even THz, allowing entirely novel applications. The ease of integration of 2D materials on any substrate allows to integrate these into Si photonics, for enhanced QEs and into CMOS platforms, for SNSPD based image arrays. Most importantly, as high temperature superconductors like BSCCO also belong to the class of 2D superconductors, the operation temperature of SNSPDs can be dramatically increased all the way up above that of liquid nitrogen > 77K.

The issue with ultra-thin 2D superconductors is that these immediately oxidize in air and lose their superconducting properties. Here the present inventors propose a solution based on the vdW assembly of heterostructures in inert atmosphere. The present inventors have used mechanical exfoliation of the high-Tc vdW materials BSCCO (or others) to prepare few vdW layers thick superconductor films (down to a thickness of 1nm). The present inventors encapsulated the superconductor with layers of other 2D vdW materials, such as the insulator hexagonal boron nitride (hBN), which fully seals and protects the superconductor from the environment. This will then allow to further prepare the device, without degrading it, following the metal contact, nanowire (or nanostrip or nanoribbon) etching and packaging steps. This will therefore enable the assembly of the full SNSPD device.

In addition to the above mentioned description of some working embodiments related to the built SNSPD, in the present section the present inventors also provide tests of all the components needed for the build-up of the proposed device. This mainly includes the fabrication of the superconducting thin films from bulk crystals, which are the active materials for the device.

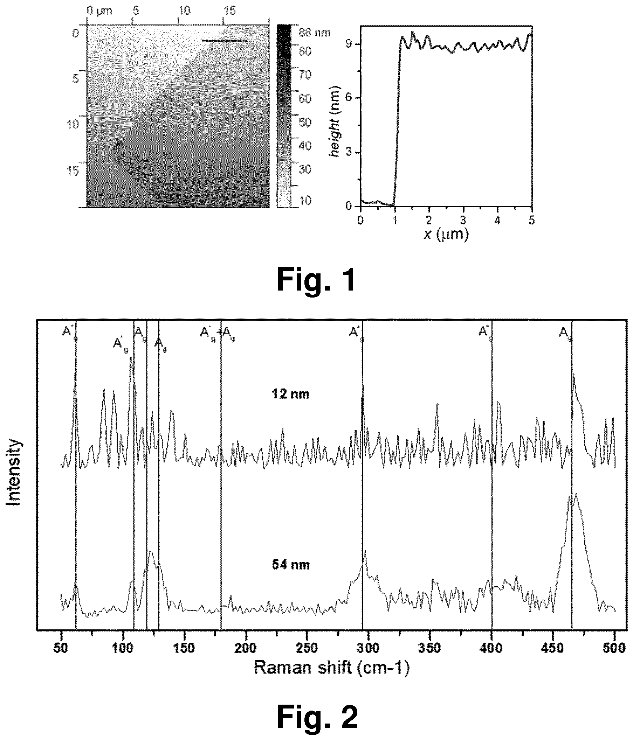

The present inventors further confirm the high morphologic and crystallographic quality of the thin films as in via atomic force microscopy (Fig. 1) and Raman spectroscopy (Fig. 2). The Raman spectroscopy experiments indicate that even in very thin films, the superconducting crystals do not lose their characteristic signatures of a highly crystalline material, which strongly contrasts thin films of conventional superconducting materials.

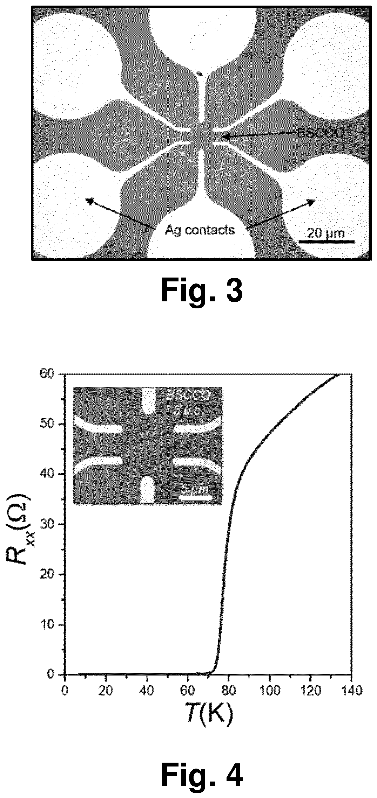

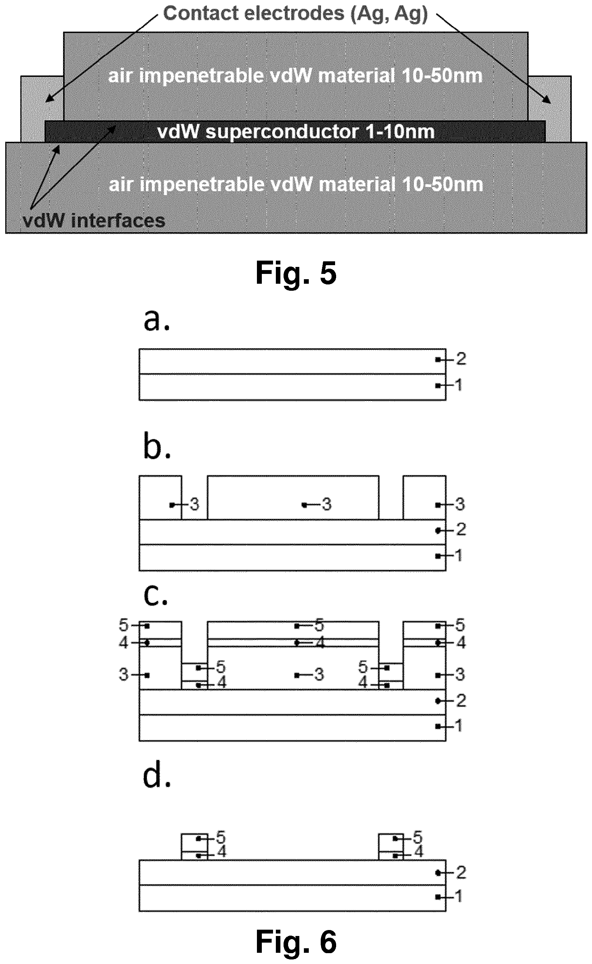

The present inventors clearly demonstrate electronic contact and transport across these devices and verify their superconducting properties above liquid nitrogen temperatures of > 77K (Fig. 3 and Fig. 4). The present inventors successfully demonstrate the vdW assembly of heterostructures in inert atmosphere where the superconductor is encapsulated with layers of hexagonal boron nitride (hBN), in order to fully seal and protect the superconductor from the environment (Fig. 5). This allows the above mentioned assembly of the full SNSPD device.

In the following, the present inventors provide a detailed description of feasible crystal handling and nanofabrication steps which allow us the successful fabrication of complete superconducting single-photon detector devices according to the present invention. The present inventors further provide a set of calculations which demonstrate both the superior single-photon detection capabilities of our used material system at temperatures of > 77K as well as possible limitations for the detection performance.

In first place, a photolithography process is performed to define bottom-contact metal electrode. The photolithography is carried out by a laser writer (LW) lithography from Microtech LW405B using a 405-nm gallium nitride diode laser. The photolithography steps are illustrated in Fig. 6. Fig. 6a indicates a silicon substrate 1 with 285 nm thermally-grown SiO₂ layer 2 used as a support for the device fabrication. Fig. 6b illustrates a 2.7 µm thick photoresist 3 (AZ 5214 E), spin coated at 4000 rpm, baked at 100°C for 1 minute and patterned by the LW. The dose is 300 mJ/cm² and the linewidth 1 µm. The photoresist 3 is developed by AZ 726 MIF developer from Microchemicals for 50 s and rinsed in DIW water for 30 s. The photoresist mask is cleaned by O₂ plasma ashing (200 mL/min, 150 W, and 2 minutes). In Fig. 6c, 3-nm titanium 4 and 50-nm gold 5 layers are subsequently deposited by electron-beam evaporation and thermal evaporation respectively using an Evaporator Lesker LAB18 system at room temperature and a base pressure of 1 × 10⁻⁷ Torr. The lift off process is carried out to by immersing sequentially the patterned substrate into sonication baths of acetone, isopropanol (IPA), and deionized water (DIW). The devices are baked at 110 °C for 10 minutes to remove solvents. Fig. 6d shows a cross-sectional illustration of as-fabricated two-terminal device. However, four-terminal devices are also prepared for sheet-resistance measurements.

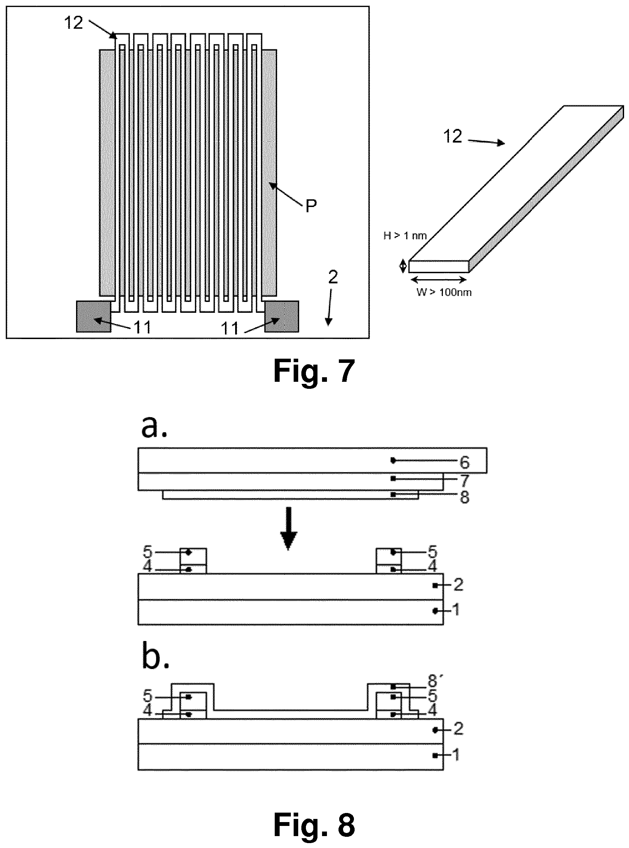

Next, the present inventors micromechanically exfoliated BSCCO and hBN flakes by cleaving bulk crystals with a Scotch tape (3M) method. To transfer BSCCO flakes onto the target substrate shown in Fig. 6d, the present inventors use polydimethylsiloxane (PDMS) deterministic transfer method shown in Fig. 8, which relies on the PDMS viscosity [DOI: 10.1039/C7CS00556C]. A PDMS film from Gel-Pack^{®} (X4 retention level and 1.5 mil gel thickness) is cut into roughly 5 mm × 5 mm stamps 7 and mounted on a glass slide 6 to pick-up the BSCCO flakes 8 from the Scotch tape. The BSCCO thickness is then inspected by a microscope in a home-built transferring stage within an Ar-glovebox, including a long-distance microscope, an X-Y microscope stage with the possibility of heating and cooling, and an X-Y-Z micromanipulator.

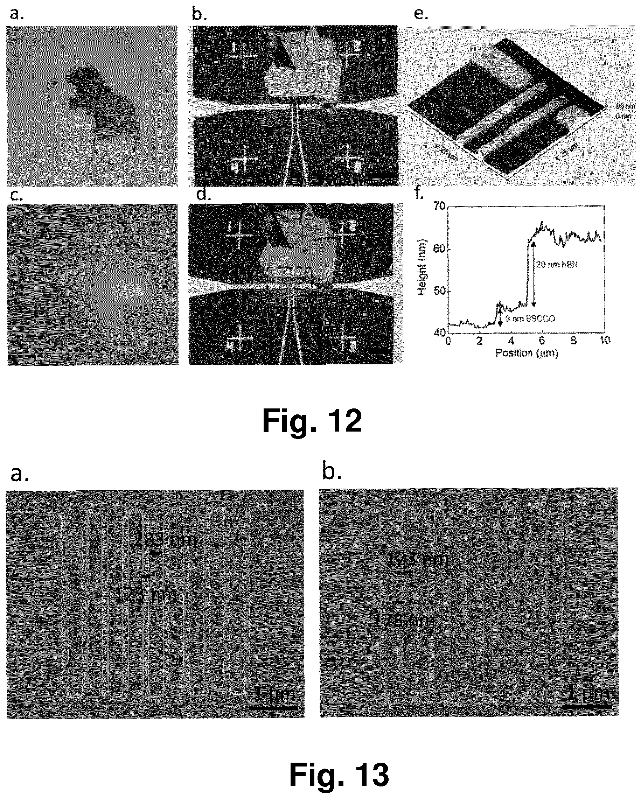

By placing the glass slide/PDMS/BSCCO-flakes blocks on top of a 285-nm SiO₂/Si wafer, it is easy to identify ultra-thin BSCCO flakes below 3 u.c. thick by simply comparing the optical contrast between the flake and the PDMS stamp (see Fig. 12a, mainly the dashed circled area). Upon finding BSCCO flakes that are 3 u.c.-thick or thinner, being possible multiples of 0.5 u.c. (1.6 nm [DOl: 10.1038/s41467-017-02104-z]), the glass slide/PDMS/BSCCO block with the BSCCO flake facing down is placed on the X-Y-Z micromanipulator, whereas the Au-electrode patterned target substrate is placed on the microscope stage. The micromanipulator with the glass slide/PDMS/BSCCO-flake is slowly lowered until the BSCCO flake 8 is in close proximity with the substrate as shown in Fig. 8a, then the BSCCO flake 8 is aligned with pre-patterned Au-electrodes 5 with precision of one micrometre, and then pushed down to bring into contact the BSCCO flake 8 with the Ti 4/Au 5 pre-patterned electrode SiO₂ substrate 2. Although the BSCCO flake 8 can be attached on the substrate at room temperature, by heating the stage at 60 °C or above the flakes are quickly brought into contact with the substrate. To detach the BSCCO flake 8, the glass slide /PDMS block is lifted up slowly, and thus the BSCCO flake 8' remains in contact with the Ti/Au electrodes on the Si/SiO₂ substrate, as illustrated in Fig. 8b.

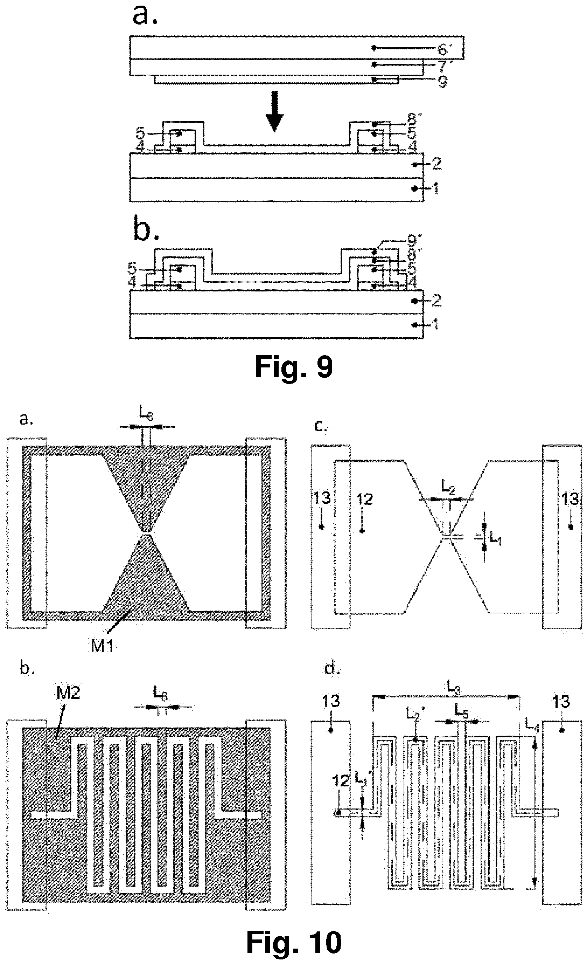

To encapsulate the BSCCO flake 8', an hBN flake is transferred on top of the BSCCO flake via the same deterministic transfer method used for the BSCCO flake. Fig. 9 illustrates the process for transferring the hBN flake. Accordingly, hBN flakes are cleaved from bulk crystals by using a Scotch tape, and then a new glass slide 6'/ PDMS 7' block is used to pick up the hBN flakes from the Scotch tape. The hBN flakes are inspected by a microscope in order to find thin flakes in the order of 1-10 nm. Immediately, the selected hBN flake 9 is transferred on top of the recently transferred BSCCO flake 8' by the abovementioned PDMS dry transfer method, see Fig. 9a. In this manner, the BSCCO flakes 8' remain encapsulated by the transferred hBN flake 9', as shown in Fig. 9b. It should be noted that sub 10-nm thin hBN flakes are desired to avoid long etching time in subsequent steps. It is also noteworthy that, owing to the high energy bandgap of hBN (5.9 eV), its transparency to visible, IR and THz spectral ranges does not limit the light absorption on those frequencies. Additionally, by performing the PDMS dry transfer method within an Argon-filled glovebox (Jacomex Glovebox GP Concept 2) with O₂ level below 0.1 ppm and H₂O level below 0.8 ppm, the present inventors ensure an inert ambient to avoid BSCCO degradation from oxidation, prior to the hBN encapsulation, and improve the cleanness and speed of the transfer compared to wet/wedging transfer methods.

The next step involves an electron beam lithography (EBL) process to define an etching mask for nanostructuring BSCCO/hBN stacks. Two etching masks (M1 and M2) are designed to render either short or long nanoribbons 12, as shown in Fig. 10a and 10b respectively, with their ends attached to respective electrodes 13. Short and narrow rod-like nanoribbons (L₁ from 100 nm to 5 µm and L₂ from 50 nm to 300 nm in Fig. 10c) offer fast operation speed due to low kinetic inductance, but suffer of low detection efficiency due to low absorption active area (i.e. L₁ × L₂ 100 nm × 100 nm). Conversely, long and narrow meander-like nanoribbons (L₂' from 500 µm to 50 mm and L₁' from 50 nm to 300 nm in Fig. 10d) offer large active area (i.e. L₃ × L₄ of 10 µm × 10 µm leads to L₂'of 500 µm) for high photon absorption efficiency at expenses of slower response due to large kinetic inductance. The interspace distance L₅ (100 nm to 5 µm) between meander lines can be optimized for optimal detection efficiency and speed.

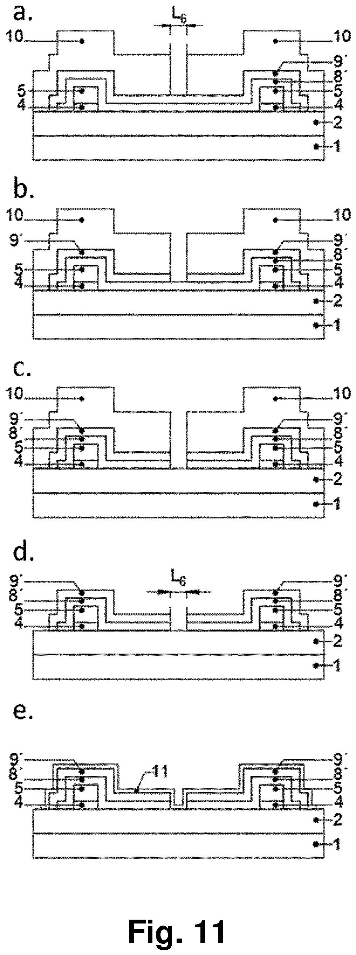

The EBL process involves spin coating a 950K PMMA layer 10 at 4000 rpm and baking at 150 °C for 2 minutes. Accordingly, a 270 nm thick electron beam resist is coated. The EBL exposure parameters are acceleration voltage of 30 KV, current of 40 pA and dose of 390 µC/cm² and the developing time is 35 seconds in Methyl isobutyl ketone:lsoprapanol (MIBK:IPA) developer in the ratio of 1:3 from Microchem. Fig. 11a depicts the resulting structure.

Next, the BSCCO/hBN stack is etched by conventional reactive ion etching (RIE) technique in an Oxford Plasmalab System 100 by two etching steps. The first step involves etching the hBN flake 9' by CHF₃/O₂ gas atmosphere (90 mTorr, CHF₃ flow rate of 40 sccm, O₂ flow rate of 4 sccm, power of 60 W, with an etching rate of 17-20 nm/min), as shown in Fig. 11b, with an etching rate of approximately 15-20 nm/min. Second, the BSCCO flake is dry etched by Argon ion milling process (Argon flow of 10 sccm, pressure of 7 mTorr, temperature of 20 °C, RF power of 300 W and ICP power of 500 W), as shown in Fig. 11c. The BSCCO etching rate is approximately 15 nm/min [Holger Motzkau Doctoral Thesis, High-frequency phenomena in small Bi2Sr2CaCu2O8+x intrinsic Josephson junctions, April 2015]. The lift-off process, which includes a Remover PG (from Microchem) clean bath at 60 °C for 20 minutes each, IPA rinse, and N₂ blow-dry, leads to the resulting structure shown in Fig. 11d. The distance L₆ refers to a random feature of the etched pattern, for example in Fig. 10a and 10b, L₆ denotes the minimum feature size to be etched. It should be noted that BSCCO edges are exposed to air after etching the hBN/BSCOO stacks. Therefore, a further hBN flake 11 dry transfer process, as that depicted in Fig. 9, on top of the etched stack is necessary to fully encapsulate the device (see Fig. 11e), according to the here described embodiment. Alternatively, dielectric coatings such as SiO₂ can serve to encapsulate the device.

Fig. 12 shows the morphology and topography of as-fabricated devices. Fig. 12a shows an optical image of a BSCCO flake picked up by a PDMS stamp from a Scotch tape. The optical contrast allows to discern the BSCCO flakes thicknesses down to a 1 u. c., as demonstrated later by AFM imaging. Fig. 12b shows the same BSCCO flake transferred by the deterministic dry transfer process described in Fig. 1 onto a Ti/Au pre-patterned Si/SiO₂ substrate. Whereas, Fig. 12c and 12d show a thin hBN flake picked up by a PDMS stamp and transferred on top of the 1 u. c. BSCCO flake respectively. An AFM image of the device topography is shown in Fig. 12e. Fig. 12f shows the height profile of the BSCCO and hBN flakes measured along the dashed line in Fig. 12e, revealing a 3-nm thick BSCCO flake, which correspond to 1 u. c., and a 20-nm thick hBN flake.

On the other hand, the morphology of meander-shaped BSCCO nanoribbons etched by the aforementioned Ar ion milling processes are depicted in Fig. 13. Figs. 13a and 13b show SEM images of 6 u. c. thick BSCCO flake patterned into six- and five-loop meanders, which widths (L₁) and spaces (L₅) are 173 nm and 123 nm for the six-loop meander and 123 nm and 283 nm for the five-loop meanders, hence indicating that the area and length of the meanders can be adjusted for optimal detection efficacy and speed.

A top schematic of the fabricated SNSPD is depicted in Fig. 7a, for an embodiment for which the high-Tc nanowire 12 is placed on a resonant photonic structure P placed on substrate 2. Fig. 7b schematically shows a perspective view of a portion of the high- Tc nanowire 12 depicted in Fig. 7a.

Although for the here described prototype bottom-contact metal electrodes have been used, for other embodiments (non-illustrated) other types of metal contacts can be provided, alternatively, such as:
1) Edge contact. This method will require etch the hBN/high-Tc/hBN stack down to the SiO2, and then deposit metal for edge contact.
2) Top contact. This method will require etch the top hBN and then slightly the high-Tc to remove any possible oxide layer on the top, and then deposit metal.

Moreover, although for the here described prototype only a top hBN (or another type of air-impenetrable vdW material) encapsulation has been provided, for other embodiments (non-illustrated) bottom and top hBN encapsulation is provided.

### Estimate of the BSCCO nanowire detector performance:

The performance is estimated assuming that the whole cross section of the nanowire is heated above the critical temperature. Compared to the hotspot model which is generally used to explain the detection mechanism of SNSPDs, the calculation performed herein by the present inventors can be regarded as a conservative estimate. In particular, the calculation only reflects the single-photon detector performance close to or at the superconducting transition. As the application of the detector is to operate the detector at or above the boiling point of nitrogen, temperatures close to or at the critical temperature are the preferred operation temperatures of the detector. The calculations are performed by calculating the temperature increase upon photon absorption from the electronic heat capacity of BSCCO. The calculation of the voltage response is performed for an exemplary SNSPD consisting of a 100 µm long nanowire which has a thickness of 5-unit cells and a lateral width of 100 nm. The calculation is based on experimental resistance data from a real BSCCO device, which exhibits a critical temperature of 88 K (compare Fig. 14 a). The voltage response ΔV as a function of the photon frequency *f*ₚ shows that the absorption of a single-photon results in a considerable voltage drop across the frequency range of 10² - 10³ THz, corresponding to wavelengths ranging from 3 µm to 300 nm (Fig. 14 b).

The expected signal to noise ratio (SNR) of the detector is also here estimated by comparing the detector's voltage response to common intrinsic noise contributions. For an exemplary detection bandwidth of 1 MHz, the present inventors find that the SNR is greater than 1 for wavelengths at or above telecommunication wavelength (1550 nm) at temperatures close to the superconducting transition (Fig. 15 a). As the calculations are based on calculating the temperature increase upon photon absorption from the electronic heat capacity of BSCCO, the SNR is highest at the critical temperature. The present inventors note, that for the actual BSCCO detector the detection can be extended to low temperatures, where the detection should be more efficient. However, the increased detection performance at low temperatures is usually described by a hotspot model relying on the breaking of cooper-pairs or a vortex anti-vortex crossing model which cannot be captured by our conservative modelling of the detection performance. Because the main application of the detector is to operate the detector at or above the boiling point of nitrogen, the present conservative modelling is a sufficient estimate for temperatures close to or at the critical temperature which is the preferred operation condition of the detector.

The detector performance can in principle be further enhanced by reducing the bandwidth of the detection circuit (Fig. 15 b). At low detection bandwidths, the detector is required to latch in order to fully capture the voltage response at low frequencies, which in turn limits the dead time of the detector. Hence, the specific design of the detection circuit (latching or non-latching operation) determines whether the single-photon detector can work for bandwidths ranging from the DC limit (single Hz) or up to 1 MHz at a wavelength of 1550 nm and up to 10 MHz at a wavelength of 532 nm.

For increasing bandwidth, the detection threshold is shifted towards higher photon frequencies (Figs. 16 a and b). For experiments up to the 1 MHz regime the detector can operate with a reasonable signal to noise ratio for detecting wavelengths at or above telecommunication wavelength (1550 nm). For wavelengths in the visible and ultraviolet, the detection bandwidth can be extended to about 10 MHz. As the detection of low energy photons is rather described by a breaking of cooper-pairs than a simple heating model, the detection of photons with a frequency even down to the THz range might be possible if the detector is operated at very low temperatures. The ultimate limit for such a detection is the energy scale of the superconducting gap, which is on the order of 10 THz in BSCCO. To this end the present inventors suggest to embed the single-photon detector in a device design which leads to a full latching of the detector in order to measure the voltage drop in the DC limit with a long integration time.

The present inventors have therefore presented a fabrication technique which allows to prepare:
1. Superconducting thin films with a superconducting transition temperature above that of the boiling point of liquid nitrogen, with an ultra-thin thickness down to 1.5nm. This technique can be applied to all compounds in the class of high-T_{c} materials such as Bi₂Sr₂Ca₂Cu₃O₁₀, Bi₂Sr₂CaCu₂O₈, Bi₂SrCa₂Cu₂O₃, Tl₂Ba₂CuO₆, YBa₂Cu₃O₇, Tl₂Ba₂CaCu₂O₈, Tl₂Ba₂Ca₂Cu₃O₁₀, TlBa₂Ca₃Cu₄O₁₁, HgBa₂CuO₄, HgBa₂CaCu₂O₆, HgBa₂Ca₂Cu₃O₈ and many more.
2. Due to the air, water and temperature sensitivity of all of these materials, thin films have to prepared in an inert atmosphere (such as a glovebox or vaccuum) and at reduced temperatures. To protect the created thin film it is crucuial to permanently and hermitacally seal it from any exposure to air or water, which would instantly degrade it. For this purpose the superconductor films are encapsulated (preferably top and bottom sandwiched) into air-impenetrable vdW materials such as hBN, MoS2, WSe₂, graphene etc., which completelly seal the superconductor from the atmosphere and further degradation. The air tight sealing is a direct consequence of the strong vdW adhession between the vdW materials which does not allow for atoms to penetrate between the layers.
3. The superconductor film can be prepared on any flat substrate (be is silicon, silicon oxide, sapphire, quartz, diamond) and can be therefore easily integrated into any type ressonant photonic structures for visible, near-IR and mid-IR light, like photonic crystal cavities, dBR cavities and many more. The superconductor thin film can also be critically coupled to antennas for THz light and lambda-half cavities for GHz wavelengths, allowing for enhanced light absorption and hence quantum efficiency of the device.
4. The device is electricaly contacted by evaporation of metal electrodes (such as Ag, Au etc.).
5. The encapsulated vdW stacks can be etched into nano-ribbons of 100nm widths using a combination of e-beam lithography and physical argon or helium ion milling. The active SC region forms the active SNSPD region, which consists of a long meander shaped nanowire with a width 50-300nm.

Based on this novel materials platform and the preparation methods thereof, it is possible to prototype a SNSPD device, which remains superconducting even at temperatures exceeding liquid nitrogen temperature T > 77K, and therefore allows to use the SNSPD concept and all the advantages thereof in a much cheaper and compact way, as it avoids expensive and bulky cooling techniques. For read-out the present inventors have used an on chip radio frequency circuit, which allows for ultra-short dead and jitter times. The entire device prototype has been packaged in a vacuum cell with direct optical access and is cooled by a cryogen-free Joule-Thompson cooler, a liquid nitrogen cell or a Peltier cooler all of which can reach temperatures below 80K.

A person skilled in the art could introduce changes and modifications in the embodiments described without departing from the scope of the invention as it is defined in the attached claims.

## Claims

1. A superconducting nanowire single-photon detector, comprising a superconducting nanowire configured and arranged for the incidence of a photon on a region thereof and the formation, on said region, of a localized non-superconducting region or hotspot, wherein said superconducting nanowire is made of a high-Tc cuprate superconductor material having a superconducting critical temperature above 77 K, **characterized in that** the thickness of said superconducting nanowire is below 1.7 nm, and **in that** said high-Tc cuprate superconductor material is at least one of Bi₂Sr₂Ca₂Cu₃O₁₀, Bi₂Sr₂CaCu₂O₈, YBa₂Cu₃O₇, Tl₂Ba₂CuO₆, Tl₂Ba₂CaCu₂O₈, Tl₂Ba₂Ca₂Cu₃O₁₀, TlBa₂Ca₃Cu₄O₁₁, HgBa₂CuO₄, HgBa₂CaCu₂O₆, HgBa₂Ca₂Cu₃O₈.

2. The superconducting nanowire single-photon detector according to any of the previous claims, wherein said high-Tc cuprate superconductor material is a 2D single-crystal material.

3. The superconducting nanowire single-photon detector according to any of the previous claims, wherein the superconducting nanowire is hermetically air- and water-sealed by means of a sealing material.

4. The superconducting nanowire single-photon detector according to claim 3, wherein the superconducting nanowire is encapsulated by said sealing material, wherein said sealing material is an air-impenetrable van der Waals material which is transparent to at least a wavelength of an electromagnetic wave associated to said photon.

5. The superconducting nanowire single-photon detector according to any of the previous claims, further comprising at least two electrodes arranged and making electrical contact with respective locations of the superconducting nanowire longitudinally distanced from each other, wherein said at least two electrodes are operatively connected with a control unit to current bias the superconducting nanowire and/or to read-out an electrical signal caused or modified by said hotspot formation.

6. The superconducting nanowire single-photon detector according to any of the previous claims, further comprising a cooler configured and arranged to maintain the temperature of said region of the superconducting nanowire above 77 K and below 120K.

7. The superconducting nanowire single-photon detector according to any of the previous claims, further comprising a vacuum cell housing the superconducting nanowire, and having direct optical access to direct a single-photon towards at least said region of the superconducting nanowire.

8. A method for obtaining a superconducting nanowire single-photon detector, comprising providing a superconducting nanowire configured and arranged for the incidence of a photon on a region thereof and the formation, on said region, of a localized non-superconducting region or hotspot, wherein said superconducting nanowire is made of a high-Tc cuprate superconductor material having a superconducting critical temperature above 77 K, **characterized in that** the thickness of said superconducting nanowire is below 1.7 nm, and **in that** said high-Tc cuprate superconductor material is at least one of Bi₂Sr₂Ca₂Cu₃O₁₀, Bi₂Sr₂CaCu₂O₈, YBa₂Cu₃O₇, Tl₂Ba₂CuO₆, Tl₂Ba₂CaCu₂O₈, Tl₂Ba₂Ca₂Cu₃O₁₀, TlBa₂Ca₃Cu₄O₁₁, HgBa₂CuO₄, HgBa₂CaCu₂O₆, HgBa₂Ca₂Cu₃O₈.

9. The method according to claim 8, comprising carrying out said step of providing said superconducting nanowire under an inert ambient.

10. The method according to claim 9, further comprising hermetically air- and water- sealing the superconducting nanowire by applying, while in said inert ambient, a sealing material thereon.

11. The method according to claim 10, comprising carrying out said step of applying a sealing material by encapsulating the superconducting nanowire, under said inert ambient, with an air-impenetrable van der Waals material which is transparent to at least a wavelength of an electromagnetic wave associated to said photon.

12. The method according to claim 11, comprising:
- providing a dielectric substrate with pre-patterned electrodes;
- exfoliating, under said inert ambient, a superconducting flake(s) from a high-Tc cuprate superconductor material bulk crystal and transferring, while in said inert ambient, the exfoliated superconducting flake(s) onto said dielectric substrate such that it is attached thereon properly aligned to make electrical contact with said pre-patterned electrodes at respective locations of the superconducting exfoliated flake(s);
- providing said air-impenetrable van der Waals material, under said inert ambient, by exfoliating the same from an air-impenetrable van der Waals material bulk crystal, and transferring the exfoliated air-impenetrable van der Waals flake(s) at least on top of the already transferred exfoliated superconducting flake(s); and
- etching the exfoliated air-impenetrable van der Waals flake(s) and the superconducting exfoliated flake(s) according to a predetermined pattern to obtain the superconducting nanowire encapsulated in the air-impenetrable van der Waals material, in the form of an etched stack.

13. The method according to claim 12, further comprising providing a further air-impenetrable van der Waals material at least on top of the etched stack, to fully encapsulate the superconducting nanowire, by carrying out, under the inert ambient, the exfoliation of the same from an air-impenetrable van der Waals material bulk crystal, and the transfer of the exfoliated air-impenetrable van der Waals flake(s) at least on top of the etched stack, covering etched and non-etched areas.

## Patentansprüche

1. Supraleitender Nanodraht-Einzelphotonendetektor, umfassend einen supraleitenden Nanodraht, der für das Auftreffen eines Photons auf einem Gebiet davon und das Bilden, auf diesem Gebiet, eines lokalisierten nicht-supraleitenden Gebiets oder Hotspots konfiguriert und angeordnet ist, wobei der supraleitende Nanodraht aus einem Hoch-Tc-Kuprat-Supraleitermaterial mit einer kritischen Supraleitungstemperatur höher als 77 K hergestellt ist, **dadurch gekennzeichnet, dass** die Dicke des supraleitenden Nanodrahts kleiner als 1,7 nm ist und dass das Hoch-Tc-Kuprat-Supraleitermaterial wenigstens eines von Bi₂Sr₂Ca₂Cu₃O₁₀, Bi₂Sr₂CaCu₂O₈, YBa₂Cu₃O₇, Tl₂Ba₂CuO₆, Tl₂Ba₂CaCu₂O₈, Tl₂Ba₂Ca₂Cu₃O₁₀, TlBa₂Ca₃Cu₄O₁₁, HgBa₂CuO₄, HgBa₂CaCu₂O₆, HgBa₂Ca₂Cu₃O₈ ist.

2. Supraleitender Nanodraht-Einzelphotonendetektor nach einem der vorhergehenden Ansprüche, wobei das Hoch-Tc-Kuprat-Supraleitermaterial ein 2D-Einkristallmaterial ist.

3. Supraleitender Nanodraht-Einzelphotonendetektor nach einem der vorhergehenden Ansprüche, wobei der supraleitende Nanodraht mit Hilfe eines Dichtungsmaterials hermetisch luft- und wasserdicht abgedichtet ist.

4. Supraleitender Nanodraht-Einzelphotonendetektor nach Anspruch 3, wobei der supraleitende Nanodraht durch das Dichtungsmaterial eingekapselt ist, wobei das Dichtungsmaterial ein luftundurchlässiges Van-der-Waals-Material ist, das für wenigstens eine Wellenlänge einer dem Photon zugeordneten elektromagnetischen Welle durchlässig ist.

5. Supraleitender Nanodraht-Einzelphotonendetektor nach einem der vorhergehenden Ansprüche, ferner umfassend wenigstens zwei Elektroden, die so angeordnet sind, dass sie einen elektrischen Kontakt mit jeweiligen Stellen des supraleitenden Nanodrahts herstellen, die in Längsrichtung voneinander beabstandet sind, wobei die wenigstens zwei Elektroden betriebstechnisch mit einer Steuereinheit verbunden sind, um einen Vorstrom an den supraleitenden Nanodraht anzulegen und/oder ein elektrisches Signal, das durch die Hotspot-Bildung verursacht oder verändert ist, auszulesen.

6. Supraleitender Nanodraht-Einzelphotonendetektor nach einem der vorhergehenden Ansprüche, der ferner ein Kühlelement umfasst, das so konfiguriert und angeordnet ist, dass es die Temperatur des Gebiets des supraleitenden Nanodrahts oberhalb von 77 K und unterhalb von 120 K hält.

7. Supraleitender Nanodraht-Einzelphotonendetektor nach einem der vorhergehenden Ansprüche, ferner umfassend eine Vakuumzelle, in der der supraleitende Nanodraht untergebracht ist und die einen direkten optischen Zugang aufweist, um ein Einzelphoton zu wenigstens dem Gebiet des supraleitenden Nanodrahtes hin zu lenken.

8. Verfahren zum Erhalten eines supraleitenden Nanodraht-Einzelphotonendetektors, umfassend Bereitstellen eines supraleitenden Nanodrahts, der für ein Auftreffen eines Photons auf einem Gebiet davon und das Bilden, auf diesem Gebiet, eines lokalisierten nicht-supraleitenden Gebiets oder Hotspots konfiguriert und angeordnet ist, wobei der supraleitende Nanodraht aus einem Hoch-Tc-Kuprat-Supraleitermaterial mit einer kritischen Supraleitungstemperatur höher als 77 K hergestellt ist, **dadurch gekennzeichnet, dass** die Dicke des supraleitenden Nanodrahts kleiner als 1,7 nm ist und dass das Hoch-Tc-Kuprat-Supraleitermaterial wenigstens eines von Bi₂Sr₂Ca₂Cu₃0₁₀, Bi₂Sr₂CaCu₂O₈, YBa₂Cu₃O₇, Tl₂Ba₂CuO₆, Tl₂Ba₂CaCu₂O₈, Tl₂Ba₂Ca₂Cu₃O₁₀, TlBa₂Ca₃Cu₄O₁₁, HgBa₂CuO₄, HgBa₂CaCu₂O₆, HgBa₂Ca₂Cu₃O₈ ist.

9. Verfahren nach Anspruch 8, umfassend Ausführen des Schritts zum Bereitstellen des supraleitenden Nanodrahtes in einer inerten Umgebung.

10. Verfahren nach Anspruch 9, ferner umfassend hermetisches luft- und wasserdichtes Abdichten des supraleitenden Nanodrahts, indem in der inerten Umgebung ein Dichtungsmaterial darauf aufgebracht wird.

11. Verfahren nach Anspruch 10, umfassend Ausführen des Schritts zum Aufbringen eines Dichtungsmaterials, indem der supraleitende Nanodraht unter der inerten Umgebung mit einem luftundurchlässigen Van-der-Waals-Material, das für wenigstens eine Wellenlänge einer dem Photon zugeordneten elektromagnetischen Welle durchlässig ist, eingekapselt wird.

12. Verfahren nach Anspruch 11, umfassend:
- Bereitstellen eines dielektrischen Substrats mit vorstrukturierten Elektroden,
- Abschälen einer oder mehrerer supraleitenden Flocke(n) aus einem Massenkristall eines Hoch-Tc-Kuprat-Supraleitermaterials unter der inerten Umgebung und Übertragen der einen oder mehreren abgeschälten supraleitenden Flocke(n) auf das dielektrische Substrat in der inerten Umgebung, so dass sie korrekt ausgerichtet darauf angebracht wird, um einen elektrischen Kontakt mit den vorstrukturierten Elektroden an entsprechenden Stellen der einen oder mehreren supraleitenden abgeschälten Flocke(n) herzustellen;
- Bereitstellen des luftundurchlässigen van-der-Waals-Materials unter der inerten Umgebung durch dessen Abschälen von einem luftundurchlässigen van-der-Waals-Material-Massenkristall und Übertragen der einen oder der mehreren abgeschälten luftundurchlässigen van-der-Waals-Flocke(n) wenigstens oben auf die die bereits eine oder mehreren bereits übertragene(n) abgeschälten supraleitenden Flocke(n); und
- Ätzen der einen oder mehreren abgeschälten luftdurchlässigen van-der-Waals-Flocke(n) und der einen oder mehreren supraleitenden abgeschälten Flocke(n) gemäß einer vorgegebenen Struktur, um den in das luftdurchlässige van-der-Waals-Material eingekapselten supraleitenden Nanodraht in Form eines geätzten Stapels zu erhalten.

13. Verfahren nach Anspruch 12, ferner umfassend Bereitstellen eines weiteren luftundurchlässigen van-der-Waals-Materials wenigstens oben auf dem geätzten Stapel, um den supraleitenden Nanodraht vollständig einzukapseln, indem unter der inerten Umgebung dessen Abschälen von einem luftundurchlässigen van-der-Waals-Material-Massenkristall ausgeführt wird, und die Übertragung der einen oder mehreren abgeschälten luftundurchlässigen van-der-Waals-Flocke(n) wenigstens oben auf den geätzten Stapel, wobei geätzte und nicht geätzte Bereiche abgedeckt werden.

## Revendications

1. Détecteur de photon unique à nanofil supraconducteur, comprenant un nanofil supraconducteur configuré et agencé pour l'incidence d'un photon sur une région de celui-ci et la formation, sur ladite région, d'une région non supraconductrice localisée ou point chaud, dans lequel ledit nanofil supraconducteur est constitué d'un matériau supraconducteur à base de cuprate à haut Tc ayant une température critique supraconductrice au-dessus de 77 K, **caractérisé en ce que** l'épaisseur dudit nanofil supraconducteur est inférieure à 1,7 nm, et **en ce que** ledit matériau supraconducteur à base de cuprate à haut Tc est au moins l'un de Bi₂Sr₂Ca₂Cu₃O₁₀, Bi₂Sr₂CaCu₂O₈, YBa₂Cu₃O₇, Tl₂Ba₂CuO₆, Tl₂Ba₂CaCu₂O₈, Tl₂Ba₂Ca₂Cu₃O₁₀, TlBa₂Ca₃Cu₄O₁₁, HgBa₂CuO₄, HgBa₂CaCu₂O₆, HgBa₂Ca₂Cu₃O₈.

2. Détecteur de photon unique à nanofil supraconducteur selon l'une quelconque des revendications précédentes, dans lequel ledit matériau supraconducteur à base de cuprate à haut Tc est un matériau monocristallin 2D.

3. Détecteur de photon unique à nanofil supraconducteur selon l'une quelconque des revendications précédentes, dans lequel le nanofil supraconducteur est hermétiquement étanchéifié à l'air et à l'eau au moyen d'un matériau d'étanchéité.

4. Détecteur de photon unique à nanofil supraconducteur selon la revendication 3, dans lequel le nanofil supraconducteur est encapsulé par ledit matériau d'étanchéité, dans lequel ledit matériau d'étanchéité est un matériau de van der Waals impénétrable par l'air qui est transparent à au moins une longueur d'onde d'une onde électromagnétique associée audit photon.

5. Détecteur de photon unique à nanofil supraconducteur selon l'une quelconque des revendications précédentes, comprenant en outre au moins deux électrodes agencées et établissant un contact électrique avec des emplacements respectifs du nanofil supraconducteur longitudinalement espacés les uns des autres, dans lequel lesdites au moins deux électrodes sont fonctionnellement connectées à une unité de commande pour polariser en courant le nanofil supraconducteur et/ou pour lire un signal électrique causé ou modifié par ladite formation de point chaud.

6. Détecteur de photon unique à nanofil supraconducteur selon l'une quelconque des revendications précédentes, comprenant en outre un refroidisseur configuré et agencé pour maintenir la température de ladite région du nanofil supraconducteur au-dessus de 77 K et au-dessous de 120 K.

7. Détecteur de photon unique à nanofil supraconducteur selon l'une quelconque des revendications précédentes, comprenant en outre une cellule à vide contenant le nanofil supraconducteur, et ayant un accès optique direct pour diriger un photon unique vers au moins ladite région du nanofil supraconducteur.

8. Procédé d'obtention d'un détecteur de photon unique à nanofil supraconducteur, comprenant la fourniture d'un nanofil supraconducteur configuré et agencé pour l'incidence d'un photon sur une région de celui-ci et la formation, sur ladite région, d'une région non supraconductrice localisée ou , dans lequel ledit nanofil supraconducteur est constitué d'un matériau supraconducteur à base de cuprate à haut Tc ayant une température critique supraconductrice au-dessus de 77 K, **caractérisé en ce que** l'épaisseur dudit nanofil supraconducteur est inférieure à 1,7 nm, et **en ce que** ledit matériau supraconducteur à base de cuprate à haut Tc est au moins l'un de Bi₂Sr₂Ca₂Cu₃O₁₀, Bi₂Sr₂CaCu₂O₈, YBa₂Cu₃O₇, Tl₂Ba₂CuO₆, Tl₂Ba₂CaCu₂O₈, Tl₂Ba₂Ca₂Cu₃O₁₀, TlBa₂Ca₃Cu₄O₁₁, HgBa₂CuO₄, HgBa₂CaCu₂O₆, HgBa₂Ca₂Cu₃O₈.

9. Procédé selon la revendication 8, comprenant la conduite de ladite étape de placement dudit nanofil supraconducteur sous une atmosphère ambiante inerte.

10. Procédé selon la revendication 9, comprenant en outre l'étanchéification hermétique à l'air et à l'eau du nanofil supraconducteur par application, toujours dans ladite atmosphère ambiante inerte, d'un matériau d'étanchéité sur celui-ci.

11. Procédé selon la revendication 10, comprenant la conduite de ladite étape d'application d'un matériau d'étanchéité par encapsulation du nanofil supraconducteur, sous ladite atmosphère ambiante inerte, avec un matériau de van der Waals impénétrable par l'air qui est transparent à au moins une longueur d'onde d'une onde électromagnétique associée audit photon.

12. Procédé selon la revendication 11, comprenant :
- la disposition sur un substrat diélectrique d'électrodes prémodelées ;
- l'exfoliation, sous ladite atmosphère ambiante inerte, d'une ou plusieurs lamelles supraconductrices à partir d'un cristal en vrac de matériau supraconducteur à base de cuprate à haut Tc et le transfert, toujours dans ladite atmosphère ambiante inerte, des une ou plusieurs lamelles supraconductrices exfoliées sur ledit substrat diélectrique de sorte qu'elles soient fixées sur celui-ci correctement alignées pour établir un contact électrique avec lesdites électrodes prémodelées à des emplacements respectifs des une ou plusieurs lamelles supraconductrices exfoliées ;
- la fourniture dudit matériau de van der Waals impénétrable par l'air, sous ladite atmosphère ambiante inerte, par exfoliation de celui-ci à partir d'un cristal en vrac de matériau de van der Waals impénétrable par l'air, et le transfert des une ou plusieurs lamelles de van der Waals impénétrables par l'air exfoliées au moins au-dessus des une ou plusieurs lamelles supraconductrices exfoliées déjà transférées ; et
- la gravure des une ou plusieurs lamelles de van der Waals impénétrables par l'air exfoliées et des une ou plusieurs lamelles supraconductrices exfoliées selon un motif prédéterminé pour obtenir le nanofil supraconducteur encapsulé dans le matériau de van der Waals impénétrable par l'air, sous la forme d'une pile gravée.

13. Procédé selon la revendication 12, comprenant en outre la fourniture d'un matériau de van der Waals impénétrable par l'air supplémentaire au moins au-dessus de la pile gravée, pour encapsuler complètement le nanofil supraconducteur, par conduite, sous l'atmosphère ambiante inerte, de l'exfoliation de celui-ci à partir d'un cristal en vrac de matériau de van der Waals impénétrable par l'air, et le transfert des une ou plusieurs lamelles de van der Waals impénétrables par l'air exfoliées au moins au-dessus de la pile gravée, de façon à recouvrir les zones gravées et non gravées.
